(19) **Europäisches Patentamt**
**European Patent Office**
**Office européen des brevets**

(11) **EP 4 694 577 A1**

(12) **EUROPEAN PATENT APPLICATION**

(43) Date of publication:
**11.02.2026 Bulletin 2026/07**

(21) Application number: **25194380.9**

(22) Date of filing: **06.08.2025**

(51) International Patent Classification (IPC):
**H05B 6/06** (2006.01)

(52) Cooperative Patent Classification (CPC):
**H05B 6/062; H05B 2213/07**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **06.08.2024 US 202418795648**

(71) Applicant: **Whirlpool Corporation**
**Benton Harbor, MI 49022 (US)**

(72) Inventors:
• **Gallivanoni, Andrea**
**Benton Harbor, 49022 (US)**
• **Stipe, Collin Andrew**
**Benton Harbor, 49022 (US)**
• **Masi, Daniele**
**Benton Harbor, 49022 (US)**
• **Musso, Gian Mauro**
**Benton Harbor, 49022 (US)**
• **Munafo, Alessandro**
**Benton Harbor, 49022 (US)**

(74) Representative: **Witte, Weller & Partner**
**Patentanwälte mbB**
**Postfach 10 54 62**
**70047 Stuttgart (DE)**

(54) **INDUCTION COOKING APPLIANCE**

(57)     An induction cooking appliance (10) includes a cooktop (12) having a cook surface (14), an induction coil (16) below the cook surface (14) and configured to heat cookware (18) on the cook surface (14), a temperature sensor (20, 22) coupled to the cooktop (12) and configured to provide a temperature signal indicative of a temperature of the cook surface (14), and control circuitry (26) in communication with the induction coil (16) and the temperature sensor. The control circuitry (26) is configured to measure an inductance $(L)$ of the induction coil (16), determine a first temperature estimate based on the inductance $(L)$, determine a second temperature estimate based on the temperature signal, estimate a temperature of the cookware (18) based on the first temperature estimate and the second temperature estimate, compare the estimated temperature of the cookware (18) to a target temperature set by a user, and control power supplied to the induction coil (16) based on the comparison.

FIG. 1

EP 4 694 577 A1

**Description**

## BACKGROUND OF THE DISCLOSURE

The present disclosure generally relates to induction cooking appliances and, more specifically, to cooking control utilizing temperature and electrical feedback in an induction cooking appliance.

## SUMMARY OF THE DISCLOSURE

According to one aspect of the present disclosure, an induction cooking appliance includes a cooktop having a cook surface, an induction coil below the cook surface and configured to heat cookware on the cook surface, a temperature sensor coupled to the cooktop and configured to provide a temperature signal indicative of a temperature of the cook surface, and control circuitry in communication with the induction coil and the temperature sensor. The control circuitry is configured to measure an inductance of the induction coil, determine a first temperature estimate based on the inductance, determine a second temperature estimate based on the temperature signal, estimate a temperature of the cookware based on the first temperature estimate and the second temperature estimate, compare the estimated temperature of the cookware to a target temperature set by a user, and control power supplied to the induction coil based on the comparison.

According to another aspect of the present disclosure, an induction cooking appliance includes a cooktop having a cook surface, an induction coil below the cook surface and configured to heat cookware on the cook surface, a temperature sensor coupled to the cooktop and configured to provide a temperature signal indicative of a temperature of the cook surface, and control circuitry in communication with the induction coil and the temperature sensor. The control circuitry is configured to measure an inductance of the induction coil, determine a first temperature estimate based on the inductance, determine a second temperature estimate based on the temperature signal, and process the first temperature estimate and the second temperature estimate a complementary filter to estimate a temperature of the cookware.

According to yet another aspect of the present disclosure, an induction cooking appliance includes a cooktop having a cook surface, an induction coil below the cook surface and configured to heat cookware on the cook surface, a temperature sensor coupled to the cooktop and configured to provide a temperature signal indicative of a temperature of the cook surface, and control circuitry in communication with the induction coil and the temperature sensor. The control circuitry is configured to measure an inductance of the induction coil and process the temperature signal and the inductance in a complementary filter to estimate a temperature of the cookware.

These and other features, advantages, and objects of the present disclosure will be further understood and appreciated by those skilled in the art by reference to the following specification, claims, and appended drawings.

## BRIEF DESCRIPTION OF THE DRAWINGS

In the drawings:

FIG. 1 is a perspective schematic view of an induction cooking appliance and a cooking vessel in accordance with various aspects described herein;
FIG. 2 is a schematic cross-sectional view of the induction cooking appliance and cooking vessel of FIG. 1 and illustrating a controller module in accordance with various aspects described herein;
FIG. 3 is a schematic cross-sectional view of the induction cooking appliance and cooking vessel of FIG. 2 and illustrating heat transfer mechanisms during operation;
FIG. 4 is a block diagram of the induction cooking appliance and cooking vessel of FIG. 1 and illustrating a temperature module in accordance with various aspects described herein;
FIG. 5 is a control diagram of an induction cooking appliance;
FIG. 6A is a listing of equations for implementation by a cooking system;
FIG. 6B is a continued listing of equations for implementation by a cooking system;
FIG. 6C is a continued listing of equations for implementation by a cooking system;
FIG. 6D is a plot of a derivative of an electrical estimation for temperature and a multiplier value over time;
FIG. 7A is a plot of temperature data and temperature estimation generated by a cooking control system using temperature-based control;
FIG. 7B is a plot of temperature data and temperature estimation generated by a cooking control system using temperature-based and electrical-based control; and
FIG. 8 is a flowchart demonstrating a method for operating an induction cooking appliance according to one aspect of the present disclosure.

The components in the figures are not necessarily to scale, emphasis instead being placed upon illustrating the principles described herein.

## DETAILED DESCRIPTION

The present illustrated embodiments reside primarily in combinations of method steps and apparatus components related to an induction cooking appliance. Accordingly, the apparatus components and method steps have been represented, where appropriate, by conventional symbols in the drawings, showing only those specific details that are pertinent to understanding the embodiments of the present disclosure so as not to obscure the disclosure with details that will be readily apparent to those of ordinary skill in the art having the benefit of the description herein. Further, like numerals in the description and drawings represent like elements.

The terms "including," "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus. An element preceded by "comprises a . . . " does not, without more constraints, preclude the existence of additional identical elements in the process, method, article, or apparatus that comprises the element.

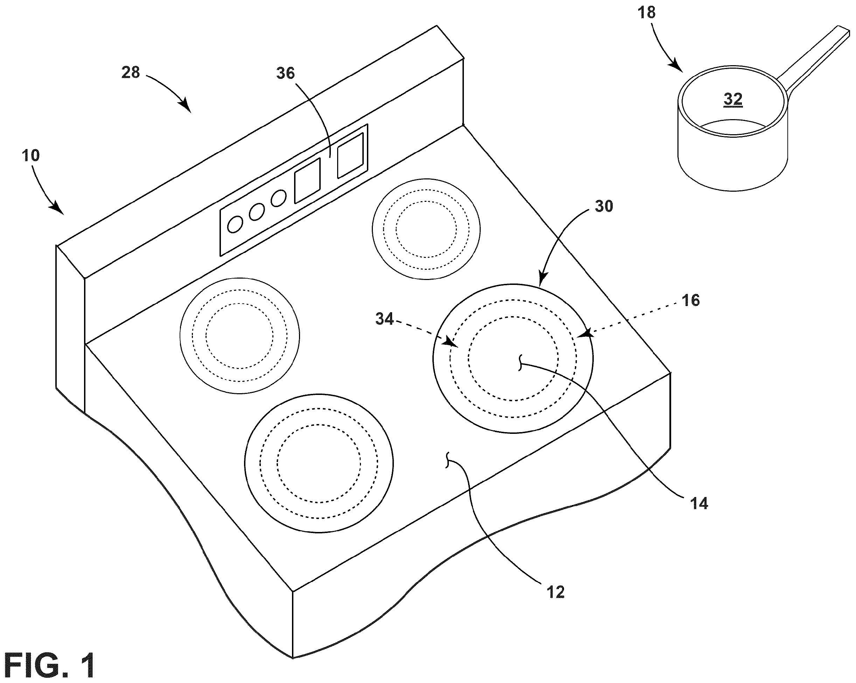

Referring to FIGS. 1-8, reference numeral 10 generally designates an induction cooking appliance. The induction cooking appliance 10 includes a cooktop 12 having a cook surface 14. An induction coil 16 is below the cook surface 14 and is configured to heat cookware 18 on the cook surface 14. The induction cooking appliance 10 includes temperature sensor 20, 22 coupled to the cooktop 12 and configured to provide a temperature signal indicative of a temperature of the cook surface 14. Control circuitry 26 is in communication with the induction coil 16, the temperature sensor 20, 22, and the power sensor 24. The control circuitry 26 is configured to measure an inductance $L$ of the induction coil 16, determine a first temperature estimate based on the inductance $L$, determine a second temperature estimate based on the temperature signal, process the first temperature estimate and the second temperature estimate in a complementary filter to estimate a temperature of the cookware 18, compare the estimated temperature of the cookware 18 to a target temperature set by a user, and control the power supplied to the induction coil 16 based on the comparison.

In some examples, a power sensor 24 is configured to provide a power signal indicative of a power supplied to the induction coil 16, and the control circuitry is configured to reduce a functional weight of the power signal in response to a rate of change of the first temperature estimate being negative.

In general, the systems and methods described herein can provide for enhanced temperature estimation, and thus, enhanced cooking experiences for an induction cooking appliance 10. The systems and methods described herein can provide efficient and accurate temperature estimation using a blended estimate based on measured thermal parameters and electrical parameters.

Turning to FIG. 1, an exemplary induction cooking system 28 includes an induction cooking appliance 10 (also referred to herein as "cooking appliance") and cookware 18, which can alternatively be referred to as one or more cooking vessels 18. The cooking appliance 10 includes a cook surface 14 that can define at least one heating zone 30 for heating the cooking vessel 18. While a single heating zone 30 is illustrated in FIG. 1, the cooking appliance 10 can include multiple heating zones 30 accommodating multiple cooking vessels 18. In addition, the cooking vessel 18 defines a cooking cavity 32 for receiving food items. In the illustrated example the cooking vessel 18 is shown as a saucepan, however the cooking vessel 18 can have any suitable form such as a frying pan, a sheet pan, a bowl, or the like.

An induction heating system 34 is provided and configured to generate heat within the cooking vessel 18 when positioned over the heating zone 30. The induction heating system 34 includes an induction coil 16 positioned beneath the cook surface 14. The cook surface 14 can include a material with a low electrical conductivity or a low thermal conductivity, such as glass or glass-ceramic in some examples. The cooking vessel 18 can include any suitable material for warming by electromagnetic induction, including ferromagnetic materials such as iron. In this manner, the cooking vessel 18 can be directly heated during operation of the induction coil 16.

The cooking appliance 10 can further include a user interface 36. The user interface 36 can be used by a user to control operation of the cooking appliance 10, including setting a cooking mode, setting a cooking temperature, or setting a timer, in some examples. The user interface 36 can include any suitable interface elements such as buttons, knobs, toggles, display screens, touch screens, light sources, or audio sources, in some examples. As shown, the user interface 36 is located on the cooking appliance 10 though this need not be the case. In some implementations, the user interface 36 can be located on a separate device, such as a mobile device, a tablet, or a central hub in some non-limiting examples. It is also contemplated that the user interface 36 can include user-interactive elements on the cooking appliance 10 and additional user-interactive elements on a separate device.

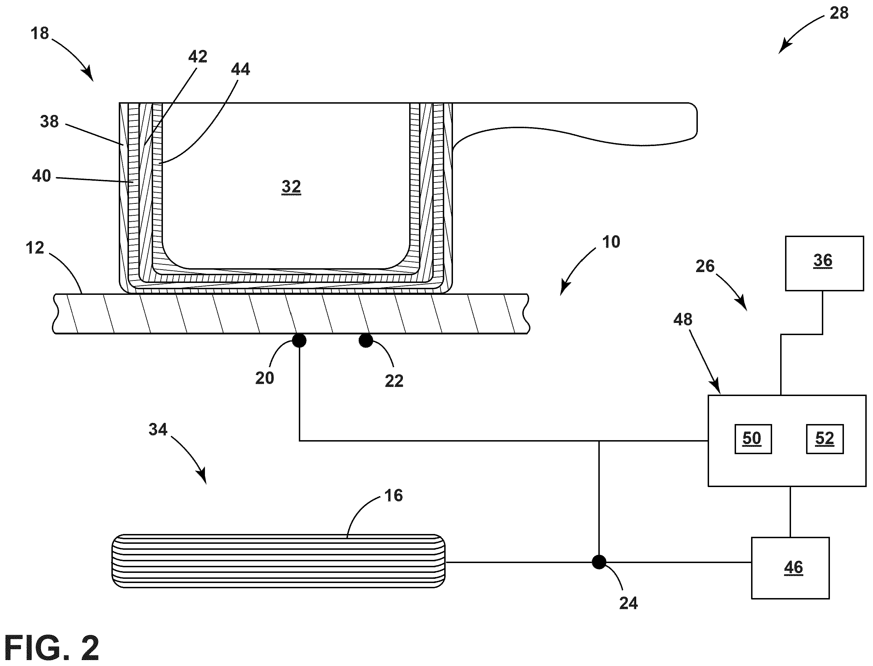

Turning to FIG. 2, a side cross-sectional view illustrates the cooking vessel 18 positioned on the cook surface 14. The induction coil 16 is schematically illustrated with wide spacing from the cook surface 14 for visual clarity, and it will be understood that the induction coil 16 can be positioned directly adjacent to the cook surface 14 or with a small gap therebetween.

The cooking vessel 18 is illustrated as having multiple stacked material layers. It will be understood that the cooking vessel 18 can include any number of layers, including only one. For instance, in some implementations, the cooking vessel 18 can have a body formed with a single material or alloy throughout.

In the exemplary implementation shown, the cooking vessel 18 includes a first layer 38, a second layer 40, a third layer 42, and a fourth layer 44. The first layer 38 defines a bottom of the cooking vessel 18 and can include a magnetic material such as magnetic steel. The second layer 40 can include aluminum, such as cast aluminum or hardened aluminum in some examples. The third layer 42 can include steel, such as magnetic steel or non-magnetic steel. The fourth layer 44 can include a non-stick material or coating, such as polytetrafluoroethylene (PTFE) or ceramic. In some implementations, the third layer 42 can be omitted and the cooking vessel 18 can be provided with a non-stick coating over the second layer 40. It is further contemplated that any of the layers 38-44 can extend over predetermined portions of the cooking vessel 18. For instance, in some implementations the first layer 38 can be provided or applied to the bottom of the cooking vessel 18 without extending up a sidewall. In this manner, the cooking vessel 18 may include a magnetic layer over a bottom portion only.

The induction heating system 34 further includes a power supply 46 electrically coupled to the induction coil 16. The power supply 46 can provide any suitable power, including alternating-current (AC) power or direct-current (DC) power. In some implementations, other components such as power converters, transformers, or the like can also be provided and configured to modify or adjust a power characteristic for the power supply 46.

A controller module 48 (also referred to herein as "controller 48") is also provided for operating the cooking appliance 10. For instance, the controller 48 can operate the cooking appliance 10 via input from a user received at the user interface 36, such as for selecting a cycle of operation and controlling the operation of the cooking appliance 10 to implement the selected cycle of operation. It is also contemplated that the controller 48 can include machine-readable instructions for partially or fully automating operation of the cooking appliance 10 without direct control from the user. Further still, in some implementations the controller 48 can be in signal communication with a local network or an external network, including by way of a wired connection or a wireless connection.

The controller 48 can be provided with at least a processor 50, such as a central processing unit (CPU), and a memory 52, for controlling and operating the cooking appliance 10. The memory 52 can be used for storing, for example, control software that is executed by the processor 50 in completing a cycle of operation using the cooking appliance 10. The memory 52 can also be used to store information, such as a database or table, and to store data received from the one or more components of the cooking appliance 10 that can be communicably coupled with the controller 48. The database or table can be used to store the various operating parameters for the cooking appliance 10, including factory default values for operating parameters and any adjustments to the factory default values by the control system or by user input. Additionally, it is contemplated that the memory 52 can store common settings, recipes, or other preferences common to the user, or any information.

The controller 48 can be communicably and operably coupled with one or more components of the cooking appliance 10 for communicating with and controlling the operation of the component to complete a cycle of operation. Such a cycle of operation can include, but is not limited to, a cooking cycle, a baking cycle, a bread-proofing cycle, a defrost cycle, or a warming cycle. More specifically, the controller 48 can be operably coupled to the power supply 46 for controlling the power output to the induction coil 16. The controller 48 can also be operably coupled with the user interface 36 for receiving user-selected inputs and communicating information to the user. For example, a user may select a temperature set point at which the user desires the temperature of the cooking vessel 18 to reach, or a cycle of operation which includes one or more temperature set points. Furthermore, the controller 48 can receive input from one or more sensors. In the implementation shown, a first temperature sensor 20 and a second temperature sensor 22 are provided, with the first temperature sensor 20 positioned centrally within the heating zone 30 and the second temperature sensor 22 positioned adjacent an edge of the heating zone 30. Any number or arrangement of temperature sensors 20, 22 can be utilized. In addition, a power sensor 24 is provided and configured to provide a signal indicative of electric power delivered to the induction coil 16. It will be understood that the electric power delivered to the induction coil 16 substantially corresponds to a thermal power delivered to the cooking vessel 18. For instance, the thermal power is delivered to the cooking vessel 18 can be between 70-100% of the electric power delivered to the induction coil 16, including between 80-100% of the electric power, including between 90-100% of the electric power, including between 95-100% of the electric power. The power sensor 24 can be configured to sense or detect a current circulating through the induction coil 16 in some implementations, or to sense or detect the electrical power directly in some implementations. It is understood that the circulating current correlates to the electrical power delivered to the induction coil 16. Furthermore, additional sensors can be provided for separate sensing or measuring of current within the induction coil 16, voltage across the induction coil 16, or electrical power delivered to the induction coil 16, in non-limiting examples. In some examples, power can be estimated by the controller 48 and the power sensor 24 can be omitted.

Such sensor input from the first temperature sensor 20, the second temperature sensor 22, or the power sensor 24 can be used by the controller 48 to controllably operate the induction cooking appliance 10, such as setting or modifying a cooking time, or a power supply to the induction coil 16, or a temperature of the cooking vessel 18, in non-limiting examples.

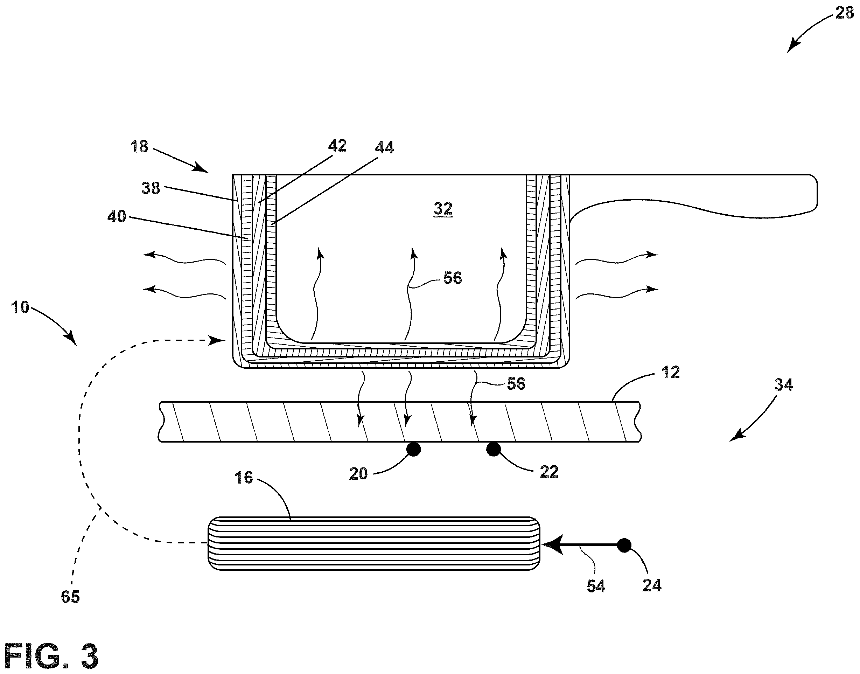

FIG. 3 illustrates some exemplary energy transfers between portions of the cooking appliance 10 and the cooking vessel 18 during operation. The cooking vessel 18, the cook surface 14, and the induction coil 16 are illustrated with exaggerated spacing distances for visual clarity.

A coil power 54 (shown with an arrow) represents the electric power delivered to the induction coil 16 by the power supply 46 (FIG. 2). A dashed arrow represents inductive heat 65 produced in the cooking vessel 18 by way of a time-varying electromagnetic field produced by the induction coil 16. Wavy arrows represent vessel heat 56 that is transferred from the cooking vessel 18 to the surrounding environment. For instance, portions of the vessel heat 56 can be conductively transferred to food items within the cooking cavity 32, conductively transferred to the cook surface 14, or convectively or radiatively transferred to the surrounding air, in non-limiting examples. In this manner, the cooking vessel 18 can be directly heated by induction via the induction coil 16, and the cook surface 14 can be indirectly heated by way of conduction from the cooking vessel 18, resulting in lower temperatures of the cook surface 14 compared to traditional cooktops.

It should be understood that the energy transfers shown in FIG. 3 are exemplary, and that other energy transfers may also be present between components of the induction cooking appliance 10 or the cooking vessel 18. For instance, the induction coil 16 can undergo Joule heating during operation, which can lead to additional warming of the cook surface 14, or of ambient air below the cook surface 14, in non-limiting examples.

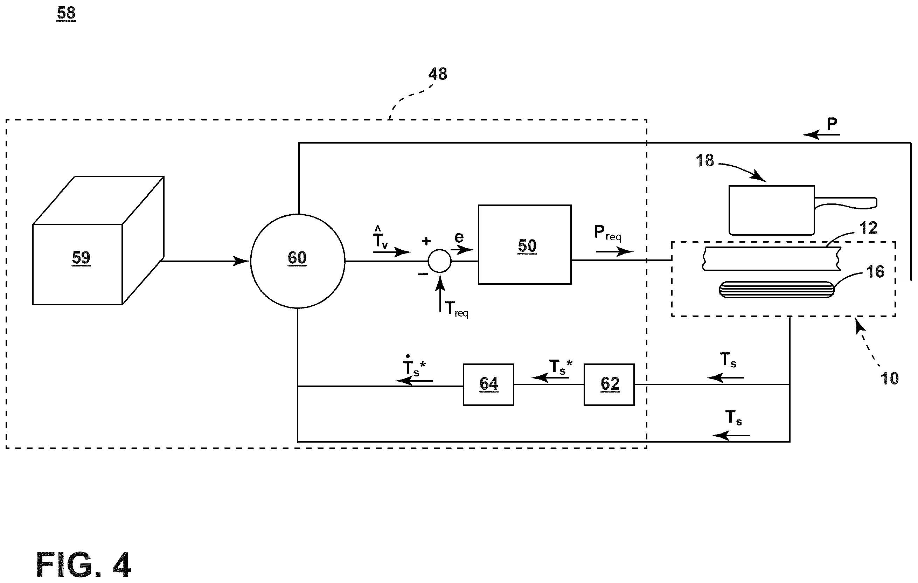

Referring now to FIG. 4, a block diagram 58 is illustrated during operation of the induction cooking appliance 10. Dashed lines are used to schematically indicate the controller module 48 and the induction cooking appliance 10 used with the cooking vessel 18.

The controller module 48 can include the processor 50, which can include a proportional-integral (PI) controller in some examples. The controller module 48 can include a parameter set 59 having one or more vessel parameters representative of a physical or thermal property of one or more cooking vessels that may be used with the induction cooking appliance 10. The controller module 48 can also include a temperature module 60 having a thermodynamic model of the cook surface 14, the cooking vessel 18, and ambient air above and/or below the cook surface. In addition, the controller module 48 can optionally include a low-pass filter 62 and a numerical differentiator 64, such as a Holo filter in one example.

During operation, the temperature module 60 can receive the parameter set 59 as well as a thermal power P, based on signals from the power sensor 24 indicative of the coil power 54, and also a temperature signal representative of a measured temperature of the cook surface 14, based on sensor signals from either or both of the first temperature sensor 20 or the second temperature sensor 22. In particular, the illustrated example shows that a sensed cook-surface temperature $T_s$ can be passed or transmitted to the low-pass filter 62 to define a filtered cook-surface temperature $T_s^*$, which is passed to the numerical differentiator 64. The numerical differentiator 64 can determine a rate of change of the filtered cook-surface temperature $\dot{T}_s^*$. Either or both of the filtered cook-surface temperature $T_s^*$ or the rate of change $\dot{T}_s^*$ thereof can be passed to the temperature module 60. Furthermore, in some implementations the sensed cook-surface temperature $T_s$ can be transmitted directly to the temperature module 60 without filtering.

The temperature module 60 can be configured to determine an estimated vessel temperature $\hat{T}_v$ based on the parameter set 59, the thermodynamic model, the cook-surface temperature $T_s$, and the thermal power P. For instance, the parameter set 59 can include a thermal exchange coefficient $\gamma_{vs}$ between the cooking vessel 18 and the cook surface 14, a thermal exchange coefficient $\gamma_{va}$ between the cooking vessel 18 and ambient air, a thermal capacity $C_v$ of the cooking vessel 18, a thermal capacity $C_s$ of the cook surface 14, a convergence rate, a power transfer efficiency, or the like. The controller 48 can store one or more function or differential equations interrelating these coefficients and capacities for different cookware 18.

It is contemplated that values in the parameter set 59 can be identified, selected, or the like to represent a wide range of cooking vessels. For instance, one or more data acquisition tests can be performed on a plurality of known cooking vessels, where the plurality of known cooking vessels defines a representative sample for all suitable cooking vessels that may be utilized with the induction cooking appliance 10. Such tests can include one or multiple temperature setpoints, and can also include closed-loop temperature data acquisition or open-loop power data acquisition in some examples. Based on the data acquisition tests, a plurality of known parameter sets 59 can be determined wherein each known cooking vessel in the plurality of known cooking vessels corresponds to one known parameter set 59 in the plurality of known parameter sets 59. In this manner, the plurality of known parameter sets 59 can define individual models representing the induction cooking appliance 10 and all known cooking vessels in the plurality of known cooking vessels. Operation of the controller module 48 can be simulated in a virtual environment using the temperature module 60 and the plurality of known parameter sets 59. Such simulation results can then be evaluated, analyzed, optimized, or the like to determine values for the parameter set 59, which defines a representative parameter set 59 for thermal exchanges between the induction cooking appliance 10 and any suitable cooking vessel that may be used therewith. Such a cooking vessel need not be included in the plurality of known cooking vessels. It is contemplated, for instance, that the plurality of known cooking vessels does not include the illustrated cooking vessel 18. In this manner, a particular cooking vessel need not be measured or calibrated prior to use with the induction cooking appliance 10.

Moreover, as the cooking vessel 18 may not be provided with a separate thermometer or temperature sensor 20, 22, it is understood that the estimated vessel temperature $\hat{T}_v$ represents an estimation of the temperature of the cookware 18. The temperature module 60 can include a block or module configured to determine an estimate for hidden parameters, such as a hidden-state observer or a Kalman filter in some examples.

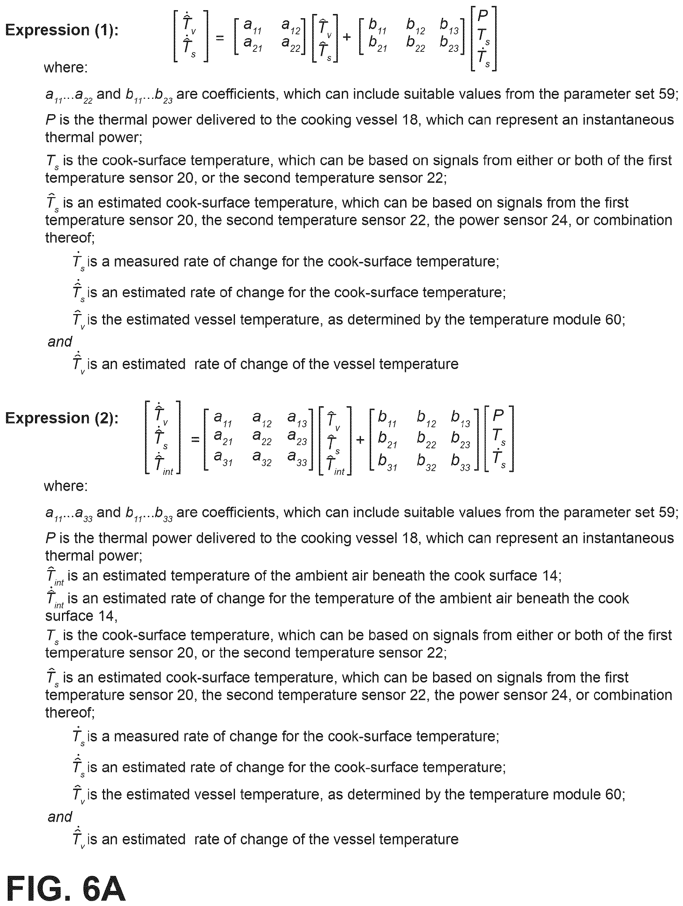

In one exemplary implementation, the temperature module 60 can include a hidden-state observer, such as a state observer as described by Isidori (see *Nonlinear Control Systems,* Springer (1995)). The state observer can be based on a thermodynamic model including a set of differential equations as shown in Expression (1) presented in FIG. 6A.

It is contemplated that the measured rate of change $\dot{T}_s$ can be determined from sampled temperature data from the first or second temperature sensors 20, 22 by way of the numerical differentiator 64. In this manner, the controller module 48 can be configured to determine the estimated vessel temperature $\hat{T}_v$ for the cooking vessel 18 during operation.

In another implementation, the temperature module 60 can include another hidden-state observer, such as an Isidori state observer, based on another thermodynamic model having another set of differential equations as shown in Expression (2) presented in FIG. 6A.

In this manner, the controller module 48 can be further configured to estimate an ambient air temperature beneath the cook surface 14 to account for localized air heating within the induction cooking appliance 10, thereby providing for improved accuracy in the estimated vessel temperature $\hat{T}_v$. For instance, the induction coil 16 can increase in temperature due to resistive heating during operation, which can cause localized warming in the air environment within the induction cooking appliance 10. It is contemplated that the ambient air temperature beneath the cook surface 14 can be estimated (e.g., the estimated ambient air temperature $\hat{T}_{int}$) as a function of either or both of the coil power 54 delivered to the induction coil 16 (FIG. 3) or the current circulating through the induction coil 16. In some examples, the ambient air temperature $\hat{T}_{int}$ can be measured via a sensor, such as via correlation to a temperature of heat sink, and/or can be measured or estimated by any other method.

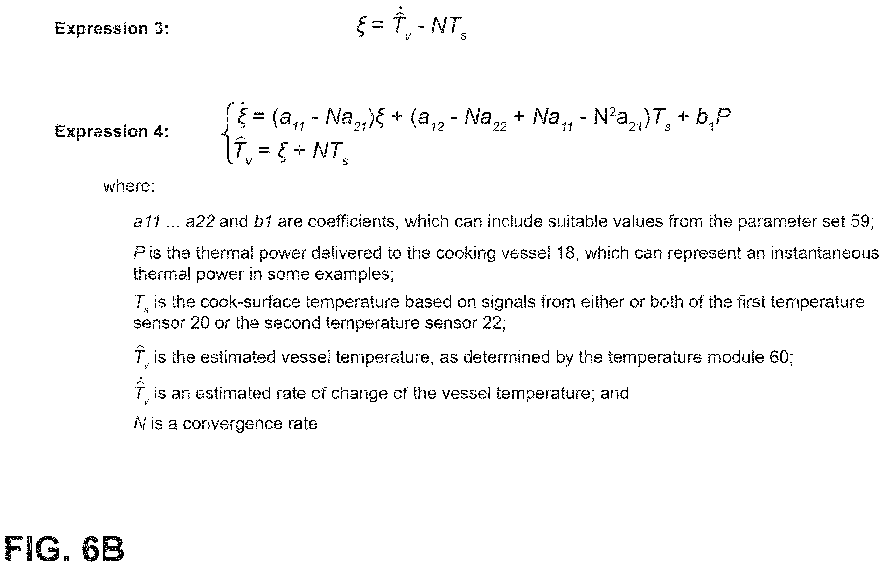

In still another implementation, the numerical differentiator 64 can be omitted from the controller module 48, such as to reduce noise in the control loop. In such a case, the temperature module 60 can include a derivative-less Isidori state observer. Particularly, by the following substitution as shown in Expression (3) presented in FIG. 6B. The temperature module 60 can include another thermodynamic model with another set of differential equations as shown in Expression (4) presented in FIG. 6B. It will also be understood that Expression (4) can be implemented as a system of equations, as described above.

Regardless of which set of expressions is utilized for the temperature module 60, the exemplary control block 58 illustrates that the temperature module 60 can determine the estimated vessel temperature $\hat{T}_v$ based on thermodynamic modeling. The controller 48 can additionally perform a comparison of the estimated vessel temperature $\hat{T}_v$ with a temperature set point $T_{req}$ for the cooking vessel 18. The temperature set point $T_{req}$ can include or represent a selected temperature setting on the user interface 36 (FIG. 1), or an automatic temperature setting as determined by the controller module 48, or a temperature setting based on a recipe or cooking instruction, in some examples. For instance, a user may select a temperature set point of 120 °C by way of the user interface 36, and the controller module 48 can compare the user-selected temperature set point $T_{req}$ with the estimated vessel temperature $\hat{T}_v$.

Further still, the processor 50 can also determine a difference or error e based on the comparison as shown. It is also contemplated that the processor 50 can controllably operate the induction heating system 34 based on the error e. For instance, in one non-limiting example of operation, a user may select a temperature set point $T_{req}$ of 105 °C by way of the user interface 36. During operation, the controller module 48 can determine an estimated vessel temperature $\hat{T}_v$ and compare with the temperature set point $T_{req}$. Based on the comparison, including based on the error e, the processor 50 can define a requested power level $P_{req}$ for the induction coil 16. In this manner, the controller 48 can be configured to controllably operate the induction cooking appliance 10 based on the comparison.

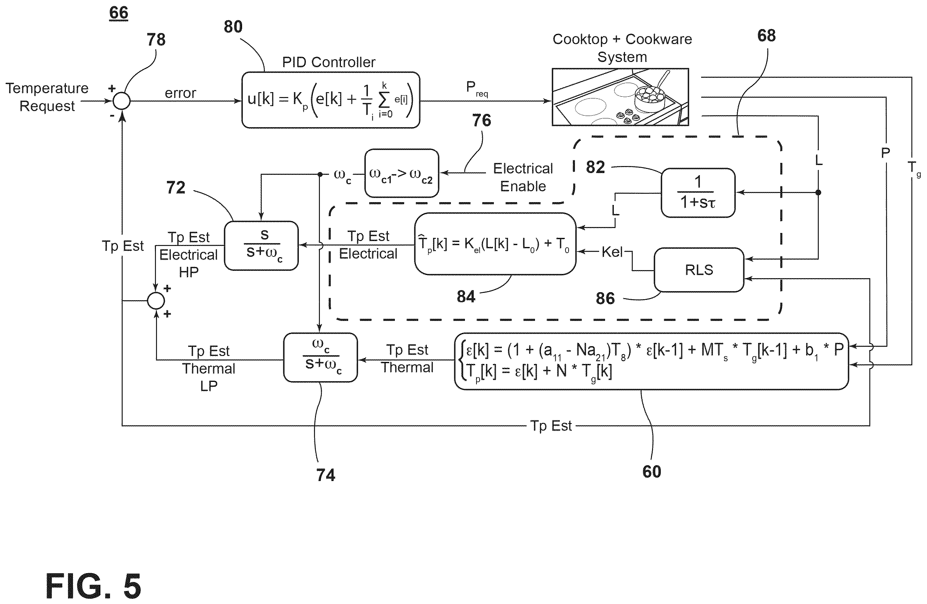

Turning now to FIGS. 5-8, the system can implement a blended estimator that provides for a more dynamic temperature estimate using both inductance $L$ temperature readings. The blended estimator, as will be described below, can gradually or suddenly bias an estimated vessel temperature $\hat{T}_v$ toward the estimation based on inductance $L$ or the estimation based on temperature. The hidden state observers previously described can therefore be utilized with the addition of inductance-based estimation (e.g., electrical estimation) to provide a more accurate estimated vessel temperature $\hat{T}_v$. Such previously-described techniques can include the thermal estimations provided in U.S. Patent Application Serial Number 18/390,402 filed on December 20, 2023, the entire contents of which is hereby incorporated by reference herein.

Referring now to FIG. 5, a second block diagram 66 demonstrates one example of temperature control carried out by a blended estimator that includes an electrical estimation block 68 and a thermal estimation block 60, which may correspond to the temperature module 60 previously described, that cooperate to allow the controller module 48 to provide the estimated vessel temperature $\hat{T}_v$. For example, a complementary filter can be provided between the electrical estimation block 68 and the thermal estimation block 60 to provide the estimated vessel temperature $\hat{T}_v$, alternatively referred to herein as the estimated cookware temperature or estimated pan

temperature $\hat{T}_p$. The complementary filter can include a high-pass filter 72 for filtering an electrical estimation $\hat{T}_{EL}$ and a second low-pass filter 74 for filtering a thermal estimation $\hat{T}_{TH}$. The estimated vessel temperature $\hat{T}_v$ of the present example demonstrated in FIGS. 5-8 can be a blend of the estimated vessel temperature $\hat{T}_v$ of the prior example described in reference to FIG. 4 and the electrical estimation $\hat{T}_{EL}$. Thus, the thermal estimation $\hat{T}_{TH}$ of the present example can correspond to the estimated vessel temperature $\hat{T}_v$ previously described.

In general, the electrical estimation block 68 can process an initial estimated vessel temperature $\hat{T}_v$ (e.g., a previous output of the estimator) and an inductance $L$ or an inductive reactance $X_L$ of the induction coil 16 to produce the electrical estimation $\hat{T}_{EL}$, and the thermal estimation block 60 can process the cook-surface temperature $T_s$, or glass temperature $T_g$, and the power $P$ drawn by the induction coil 16 to determine the thermal estimate $\hat{T}_{TH}$. An enable control 76 is configured to control the complementary filter to bias the estimate of the temperature of the cookware 18 in favor of either the electrical estimate or the thermal estimate $\hat{T}_{TH}$. For example, the complementary filter can be used to blend the electrical estimate and the thermal estimate $\hat{T}_{TH}$ to produce the estimated vessel temperature $\hat{T}_v$ across several scenarios, such as entry of cold food into a warming pan, preheating, or any other heating process. The estimated vessel temperature $\hat{T}_v$ is processed in a first comparator 78 in which a difference between the temperature request and the estimated vessel temperature $\hat{T}_v$ is calculated, thereby indicating an error. The power request $P_{req}$ to the coil is then determined using a PID controller 80 that processes the error. Power $P$ is then provided to the induction coil 16. The measured power $P$ drawn by the induction coil 16, the inductance $L$, the cook-surface temperature $T_s$ are then processed in the estimator as described above.

The thermal estimation block 60 can employ the temperature module 60 previously described, which can employ any of the hidden state observers previously described and/or Kalman filters previously described (e.g., an Isodori hidden state observer). For example, the temperature module 60 can implement the set of differential equations as shown in Expression (6) or another expression described herein (e.g., Expressions (1), (2), or (4)). In some implementations, the temperature module 60 can employ the thermodynamic model shown in the temperature module 60 of FIG. 5. An unfiltered thermal estimation $\hat{T}_{TH}$ output by the temperature module 60 is processed in the second low-pass filter 74. Based on the state of the enable control 76, the second low-pass filter 74 will weight, or otherwise act as a switch for, the thermal estimation $\hat{T}_{TH}$ to control how much the estimated vessel temperature $\hat{T}_v$ is biased toward the thermal estimation $\hat{T}_{TH}$ relative to the electrical estimation $\hat{T}_{EL}$. For example, when a first cutoff frequency $\omega_c$ is set to a high value relative to a complex variable input, the thermal estimation $\hat{T}_{TH}$ can be weighted more heavily than the electrical temperature estimation, and when the first cutoff frequency $\omega_c$ is a low value relative to a complex variable input, the electrical temperature estimation can be weighted more heavily than the thermal estimation $\hat{T}_{TH}$.

In general, the electrical estimation $\hat{T}_{EL}$ can have a faster response time to sudden changes in measured temperature relative to a response time of the thermal estimation $\hat{T}_{TH}$ due to the electrical estimation $\hat{T}_{EL}$ being based on inductive reactance $X_L$. For example, the inductive reactance $X_L$ can change nearly immediately in response to a sudden temperature change relative to detection using only the thermal estimation $\hat{T}_{TH}$ (e.g., based on temperature sensors 20, 22). The inductive reactance $X_L$ can be determined at a constant switching frequency. During steady state temperature changes (e.g., lower rates of change of the temperature), the thermal estimation $\hat{T}_{TH}$ can be more accurate than the electrical estimation $\hat{T}_{EL}$ due to a direct correlation between the cook-surface temperature $T_s$ and the vessel temperature.

With continued reference FIG. 5, the electrical estimation $\hat{T}_{EL}$ is calculated based on the empirical observation that inductive reactance $X_L$ is proportional to the temperature of the bottom of the cookware 18, as indicated by the equation of Expression (5) shown in FIG. 6B. The electrical estimation $\hat{T}_{EL}$ is dependent on a proportionality constant $K_{el}$. As the proportionality constant $K_{el}$ controls how much the inductive reactance $X_L$ influences the estimated vessel temperature $\hat{T}_v$. The initial inductive reactance $X_{L0}$ and/or the inductance $L_0$ can be measured by the system when the cookware 18 is first placed in the heating zone 30 over the induction coil 16 and by using various mechanisms known in the art, for example, a resistance circuit or any electrical circuit or sensor operable to detect inductance $L$ or inductive reactance $X_L$. The inductive reactance $X_L$ can be proportional to a product of the frequency and the inductance $L$.

Still referring to the electrical estimation block 68 of the estimator, at an initial filtering stage, the inductance $L$ is processed in a third low-pass filter 82 which can attenuate all induction values above a second cutoff frequency $\tau$ to filter measurement noise. The filtered inductance $L$ is fed into an electrical module 84 along with the proportionality constant $K_{el}$. As described above, the proportionality constant $K_{el}$ can be determined based at least partially on parameters of the parameter set 59.

As illustrated in FIG. 5, an estimation block 86 can be provided for determining the proportionality constant $K_{el}$ during a cooking process (e.g., based on the parameter set 59 and active inputs). For example, the estimation block 86 can be a recursive estimator, such as a recursive least square estimator or other estimator that processes the inductance $L$ and the estimated vessel temperature $\hat{T}_v$ to determine the proportionality constant $K_{el}$. In one implementation, the estimation block 86 determines the proportionality constant $K_{el}$ based on the inductance L and the estimated vessel temperature $\hat{T}_v$,

along with the parameter set 59 during a preheat phase of the cookware 18. It is possible to rely on the cookware 18 being in a known condition for the estimation of the proportionality constant $K_{el}$.

In order to not abruptly change the internal state of the hidden state observer, the electrical estimation $\hat{T}_{EL}$ is gradually blended into calculation of the estimated vessel temperature $\hat{T}_v$ by varying the first cutoff frequency $\omega_c$. This adjustment performed by the controller 48 allows the system to control the functional weight of the thermal estimation $\hat{T}_{TH}$ and the electrical estimation $\hat{T}_{EL}$ to bias the estimated vessel temperature $\hat{T}_v$ toward either the electrical estimation $\hat{T}_{EL}$ or the thermal estimation $\hat{T}_{TH}$. In some examples, rather than gradually blending the electrical estimation $\hat{T}_{EL}$ (e.g., slowly decreasing the first cutoff frequency $\omega_c$), the control module 48 can instead re-initialize (e.g., the first cutoff frequency $\omega_c$ can change abruptly, the internal state of the filters 72, 74 and/or the estimator can reset). Thus, the controller 48 can control the estimated vessel temperature $\hat{T}_v$ by controlling the bias in various ways and responsive to different cooking conditions. As will be described below, in the event of food insertion into the cookware 18, a quick temperature change can occur, and the controller 48 can re-initialize the high-pass filter 72 to provide a quicker transition to produce a more accurate estimated vessel temperature $\hat{T}_v$.

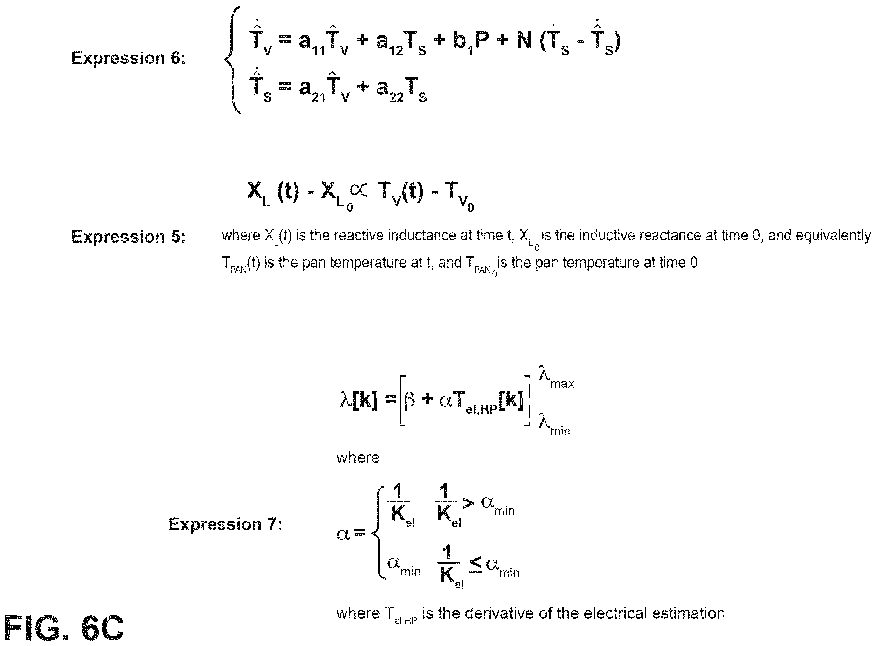

To track changes in the estimated vessel temperature $\hat{T}_v$ and a change in the cook-surface temperature $T_s$, the temperature module 60 can implement the equation represented by Expression (6) as represented in FIG. 6C, which can include variables representative of the cook-surface temperature $T_s$, a rate of change of the measured cook-surface temperature $\dot{T}_s$, the estimated vessel temperature $\hat{T}_v$, and the power drawn by the induction coil 16. By factoring in the power P drawn by the induction coil 16, sudden temperature changes can be detected, and the controller 48 can bias the estimated vessel temperature $\hat{T}_v$ toward the electrical estimation $\hat{T}_{EL}$ in response to the sudden temperature changes. Similarly, the controller 48 can bias the estimated vessel temperature $\hat{T}_v$ toward the thermal estimation $\hat{T}_{TH}$ in steady state conditions, such as during gradual temperature increases occurring during preheat.

In particular, the hidden state observer can factor in on-line, or active, adjustment by including a multiplier $b_1$ for the power P, as shown in the equation of Expression (6) demonstrated in FIG. 6C. The multiplier $b_1$ can be modified by the system, as described herein. In operation, the electrical estimation $\hat{T}_{EL}$ is heavily biased by setting the value of the first cutoff frequency $\omega_c$ to quickly increase the power request $P_{req}$ to be delivered to the cookware 18 when food is inserted, to compensate for the food insertion bringing the temperature down. However, by maintaining a fixed, large value for of multiplier $b_1$, the effect of the food insertion would be a large change in the estimated vessel temperature $\hat{T}_v$. In other words, the large increase in power $P$ would drive a corresponding increase in the estimated vessel temperature $\hat{T}_v$, thereby counteracting the effect of the electrical estimation $\hat{T}_{EL}$. Accordingly, the value of the multiplier $b_1$ can be variable to control the functional weight of the power $P$ for determining the estimated vessel temperature $\hat{T}_v$ and/or the change in the estimated vessel temperature $\hat{T}_v$.

With continued reference to the equations of FIG. 6C, the value of the multiplier $b_1$ can be controlled based on a derivative of the electrical estimation $T_{EL,HP}$. With reference to Expression 7, the multiplier $b_1$ can be selected on or off by a selection factor $\lambda$. The selection factor $\lambda$ is a function of the derivative of the electrical estimation $T_{EL,HP}$, and tuning parameters (e.g., a y-intercept $\beta$, and a slope $\alpha$). The tuning parameters $\beta$, $\alpha$ can be pre-set or adjusted. Any other linear or nonlinear function can be used for enabling the multiplier $b_1$.

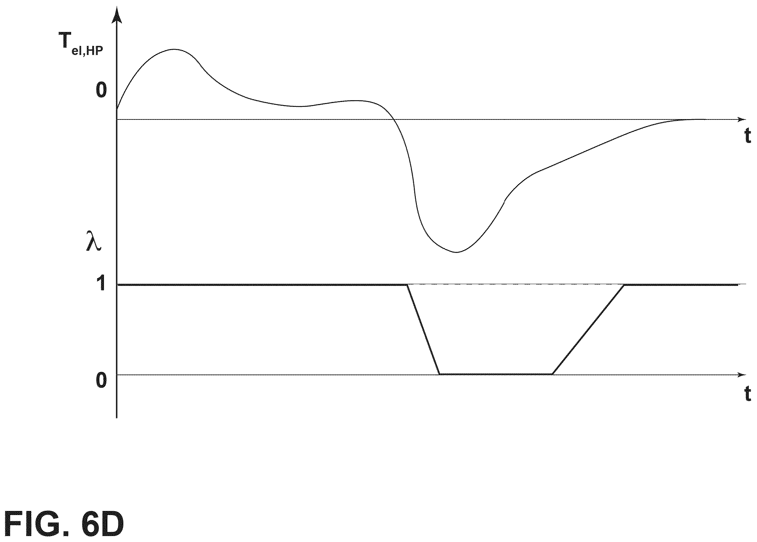

Referring now to FIG. 6D, a plot of the derivative of the electrical estimation $T_{EL,HP}$, as well as the selection factor $\lambda$, is plotted along time. The selection factor $\lambda$ can be a value between 0 and 1. To limit the effects that power $P$ has on the estimated vessel temperature $\hat{T}_v$, the selection factor $\lambda$ is set to 0, either instantly or gradually, in response to the derivative of the electrical estimate being zero or being negative. As demonstrated in FIG. 6D, initially (during preheating), the derivative of the electrical estimation $T_{EL,HP}$ is positive to due temperature increase, while the dip into a negative derivative of the electrical estimation $T_{EL,HP}$ is due to the food insertion. It is contemplated that the selection factor $\lambda$ can be a value between any other values.

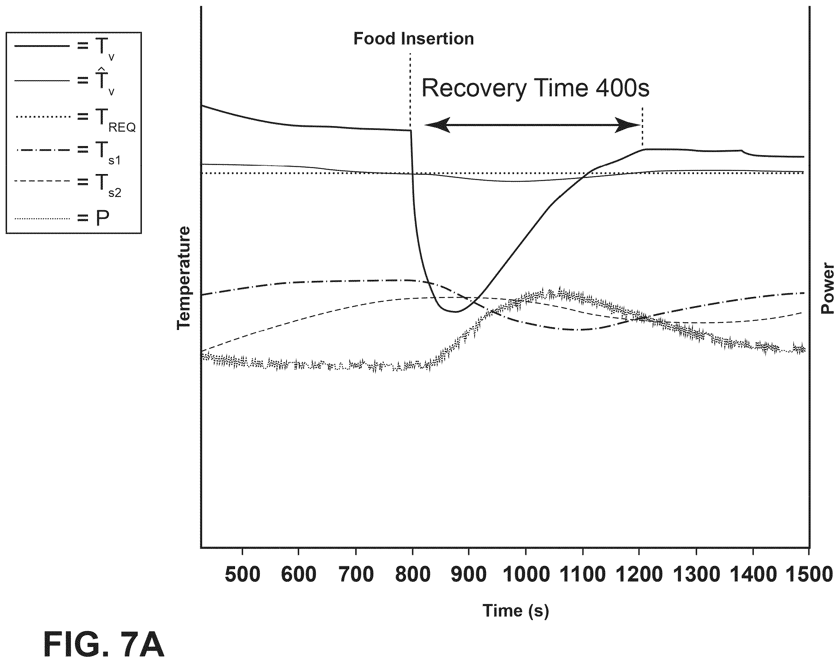

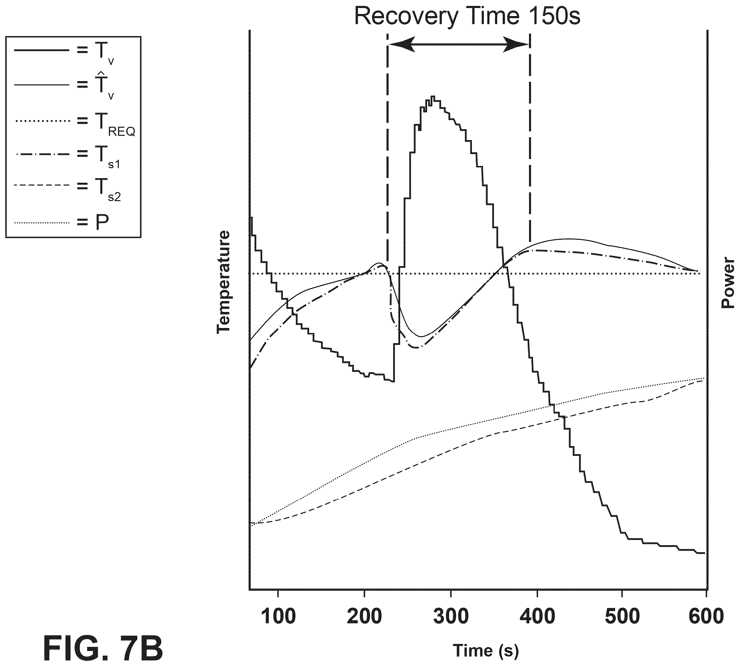

Referring now to FIGS. 7A and 7B, differences between the estimated vessel temperature $\hat{T}_v$ as determined by the thermal model (a first plot, FIG. 7A) can be different as compared to the estimated vessel temperature $\hat{T}_v$ as determined by the blended model (a second plot, FIG. 7B). In the first plot, the "recovery time," or period of accurate temperature estimation, between an exemplary food insertion event and a stable estimated vessel temperature $\hat{T}_v$ is 400 seconds. As demonstrated in the second plot, the recovery time for a similar exemplary food insertion event is 150 seconds. The present systems and methods can thus provide for enhanced temperature estimation and therefore, an enhanced cooking experience.

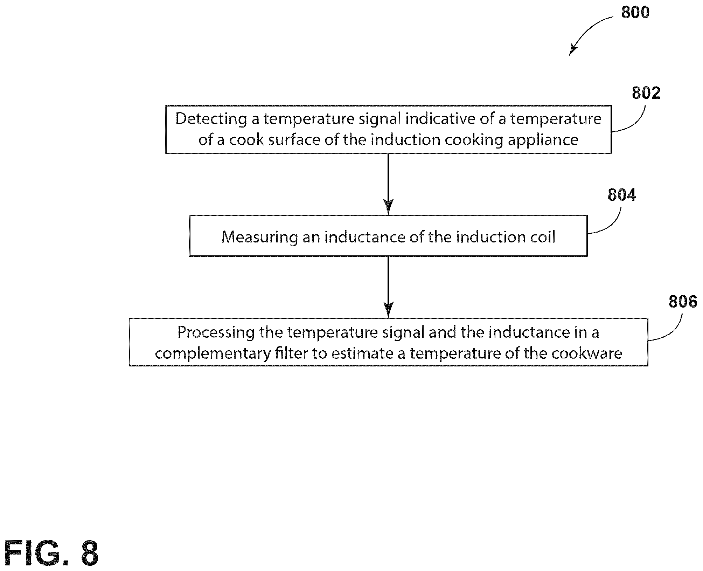

Referring now to FIG. 8, a method 800 for operating an induction cooktop appliance includes detecting a temperature signal indicative of a temperature of a cook surface 14 of the induction cooking appliance 10 at step 802. The method 800 further includes measuring an inductance of the induction coil 16 at step 804. The method 800 further includes processing the temperature signal and the inductance in a complementary filter to estimate a temperature of the cookware 18 at step 806.

According to one aspect of the present disclosure, an induction cooking appliance includes a cooktop having a cook surface, an induction coil below the cook surface and configured to heat cookware on the cook surface, a temperature sensor coupled to the cooktop and configured to provide a temperature signal indicative of a temperature of the cook surface, and control circuitry in communication with the induction coil and the temperature sensor. The control circuitry is configured to measure an inductance of the induction coil, determine a first temperature estimate based on the inductance, determine a second temperature estimate based on the temperature signal, estimate a temperature of the cookware based on the first temperature estimate and the second temperature estimate, compare the estimated temperature of the cookware to a target temperature set by a user, and control power supplied to the induction coil based on the comparison.

According to one aspect of the present disclosure, the estimation of the temperature of the cookware is obtained using a complementary filter comprising a high-pass filter that processes the first temperature estimate and a low-pass filter that processes the second temperature estimate.

According to one aspect of the present disclosure, the control circuitry includes a controller operating a hidden-state observer to estimate the temperature of the cookware.

According to one aspect of the present disclosure, the hidden-state observer includes an Isodori State Observer.

According to one aspect of the present disclosure, the hidden-state observer includes a derivative-less Isodori State Observer.

According to one aspect of the present disclosure, the control circuitry is configured to adjust a crossover frequency of the complementary filter to control a functional weight of the inductance and the temperature signal for calculation of the estimated temperature.

According to one aspect of the present disclosure, the control circuitry is configured to bias the estimation of the estimated temperature toward one of the first temperature estimate and the second temperature estimate.

According to one aspect of the present disclosure, the control circuitry is configured to detect food insertion onto the cookware based on the inductance and bias the estimated temperature toward the first temperature estimate in response to the food insertion.

According to one aspect of the present disclosure, the control circuitry is configured to determine a rate of change of the first temperature estimate and adjust the estimated temperature based on the rate of change of the first temperature estimate.

According to one aspect of the present disclosure, the induction cooking appliance includes a power sensor that detects the power drawn by the induction coil, wherein the second temperature estimate is based on the power.

According to one aspect of the present disclosure, the control circuitry is configured to limit a functional weight of the power when the rate of change of the first temperature estimate is negative.

According to one aspect of the present disclosure, an induction cooking appliance includes a cooktop having a cook surface, an induction coil below the cook surface and configured to heat cookware on the cook surface, a temperature sensor coupled to the cooktop and configured to provide a temperature signal indicative of a temperature of the cook surface, and control circuitry in communication with the induction coil and the temperature sensor. The control circuitry is configured to measure an inductance of the induction coil, determine a first temperature estimate based on the inductance, determine a second temperature estimate based on the temperature signal, and process the first temperature estimate and the second temperature estimate a complementary filter to estimate a temperature of the cookware.

According to one aspect of the present disclosure, estimation of the temperature of the cookware includes processing the inductance in a high-pass a high-pass filter and processing the temperature signal in a low-pass filter.

According to one aspect of the present disclosure, the control circuitry includes a controller operating a hidden-state observer to estimate the temperature of the cookware.

According to one aspect of the present disclosure, the control circuitry is configured to adjust a crossover frequency of the high-pass filter and the low-pass filter to control a functional weight of the inductance and the temperature signal, respectively, for calculation of the estimated temperature.

According to one aspect of the present disclosure, the control circuitry is configured to bias the estimation of the estimated temperature toward one of the first temperature estimate and the second temperature estimate.

According to one aspect of the present disclosure, the control circuitry is configured to detect food insertion onto the cookware based on the inductance and bias the estimated temperature toward the first temperature estimate in response to the food insertion.

According to one aspect of the present disclosure, the control circuitry is configured to compare the estimated temperature of the cookware to a target temperature set by a user and control the power supplied to the induction coil based on the comparison.

According to one aspect of the present disclosure, an induction cooking appliance includes a cooktop having a cook surface, an induction coil below the cook surface and configured to heat cookware on the cook surface, a temperature sensor coupled to the cooktop and configured to provide a temperature signal indicative of a temperature of the cook surface, and control circuitry in communication with the induction coil and the temperature sensor. The control circuitry is configured to measure an inductance of the induction coil and process the temperature signal and the inductance in a complementary filter to estimate a temperature of the cookware.

According to one aspect of the present disclosure, the control circuitry is configured to compare the estimated temperature of the cookware to a target temperature set by a user and control power supplied to the induction coil based on the comparison.

According to another aspect, a method for operating an induction cooking appliance includes detecting a temperature signal indicative of a temperature of a cook surface of said induction cooking appliance, measuring an inductance of the induction coil, and processing the temperature signal and the inductance in a complementary filter to estimate a temperature of the cookware.

According to another aspect, the method further includes processing the inductance in a low-pass filter, processing the temperature signal in a high-pass filter, and determining the estimated temperature of the cookware based on outputs from the low-pass filter and the high-pass filter.

According to another aspect, the method further includes determining a first temperature estimate based on the inductance, determining a second temperature estimate based on the temperature signal, and biasing the estimated temperature toward one of the first temperature estimate and the second temperature estimate.

According to another aspect, the method includes detecting food insertion onto the cookware based on the inductance, and biasing the temperature estimate toward the first temperature estimate in response to the food insertion.

According to another aspect, the method includes determining a rate of change of the first temperature estimate, and adjusting estimation of the estimated temperature based on the rate of change of the first temperature estimate.

According to another aspect, the method includes detecting a power drawn by the induction coil, wherein the second temperature estimate is based on the power.

According to another aspect, the method includes limiting a functional weight of the power when the rate of change of the first temperature estimate is zero.

It will be understood by one having ordinary skill in the art that construction of the described disclosure and other components is not limited to any specific material. Other exemplary embodiments of the disclosure disclosed herein may be formed from a wide variety of materials, unless described otherwise herein.

For purposes of this disclosure, the term "coupled" (in all of its forms, couple, coupling, coupled, etc.) generally means the joining of two components (electrical or mechanical) directly or indirectly to one another. Such joining may be stationary in nature or movable in nature. Such joining may be achieved with the two components (electrical or mechanical) and any additional intermediate members being integrally formed as a single unitary body with one another or with the two components. Such joining may be permanent in nature or may be removable or releasable in nature unless otherwise stated.

It is also important to note that the construction and arrangement of the elements of the disclosure as shown in the exemplary embodiments is illustrative only. Although only a few embodiments of the present innovations have been described in detail in this disclosure, those skilled in the art who review this disclosure will readily appreciate that many modifications are possible (e.g., variations in sizes, dimensions, structures, shapes and proportions of the various elements, values of parameters, mounting arrangements, use of materials, colors, orientations, etc.) without materially departing from the novel teachings and advantages of the subject matter recited. For example, elements shown as integrally formed may be constructed of multiple parts or elements shown as multiple parts may be integrally formed, the operation of the interfaces may be reversed or otherwise varied, the length or width of the structures and/or members or connector or other elements of the system may be varied, the nature or number of adjustment positions provided between the elements may be varied. It should be noted that the elements and/or assemblies of the system may be constructed from any of a wide variety of materials that provide sufficient strength or durability, in any of a wide variety of colors, textures, and combinations. Accordingly, all such modifications are intended to be included within the scope of the present innovations. Other substitutions, modifications, changes, and omissions may be made in the design, operating conditions, and arrangement of the desired and other exemplary embodiments without departing from the spirit of the present innovations.

It will be understood that any described processes or steps within described processes may be combined with other disclosed processes or steps to form structures within the scope of the present disclosure. The exemplary structures and processes disclosed herein are for illustrative purposes and are not to be construed as limiting.

**Claims**

1. An induction cooking appliance (10), comprising:

    a cooktop (12) having a cook surface (14);
    an induction coil (16) below the cook surface (14) and configured to heat cookware (18) on the cook surface (14);
    a temperature sensor (20, 22) coupled to the cooktop (12) and configured to provide a temperature signal indicative of a temperature of the cook surface (14); and
    control circuitry (26) in communication with the induction coil (16) and the temperature sensor (20, 22), the control circuitry (26) configured to:

measure an inductance (L) of the induction coil (16);

determine a first temperature estimate based on the inductance (L);

determine a second temperature estimate based on the temperature signal;

estimate a temperature of the cookware (18) based on the first temperature estimate and the second temperature estimate;

compare the estimated temperature of the cookware (18) to a target temperature set by a user; and

control power supplied to the induction coil (16) based on the comparison.

2. The induction cooking appliance (10) of claim 1, wherein the estimation of the temperature of the cookware (18) is obtained using a complementary filter comprising a high-pass filter (72) that processes the first temperature estimate and a low-pass filter (62) that processes the second temperature estimate.

3. The induction cooking appliance (10) of either one of claims 1 or 2, wherein the control circuitry (26) includes a controller (48) operating a hidden-state observer to estimate the temperature of the cookware (18).

4. The induction cooking appliance (10) of claim 3, wherein the hidden-state observer includes an Isodori State Observer.

5. The induction cooking appliance (10) of claim 3, wherein the hidden-state observer includes a derivative-less Isodori State Observer.

6. The induction cooking appliance (10) of either one of claims 3 or 4, wherein the control circuitry (26) is configured to adjust a crossover frequency of the complementary filter to control a functional weight of the inductance (L) and the temperature signal for calculation of the estimated temperature.

7. The induction cooking appliance (10) of any one of claims 1-6, wherein the control circuitry (26) is configured to bias the estimation of the estimated temperature toward one of the first temperature estimate and the second temperature estimate.

8. The induction cooking appliance (10) of any one of claims 1-7, wherein the control circuitry (26) is configured to:

detect food insertion onto the cookware (18) based on the inductance (L); and
bias the estimated temperature toward the first temperature estimate in response to the food insertion.

9. The induction cooking appliance (10) of any one of claims 1-7, wherein the control circuitry (26) is configured to:

determine a rate of change of the first temperature estimate; and
adjust the estimated temperature based on the rate of change of the first temperature estimate.

10. The induction cooking appliance (10) of claim 9, further comprising:
a power sensor (24) that detects the power (P) drawn by the induction coil (16), wherein the second temperature estimate is based on the power (P).

11. The induction cooking appliance (10) of claim 10, wherein the control circuitry (26) is configured to limit a functional weight of the power (P) when the rate of change of the first temperature estimate is negative.

12. The induction cooking appliance (10) of either one of claims 10 or 11, wherein the power sensor (24) is configured to sense current.

13. The induction cooking appliance (10) of any one of claims 10-12, wherein the control circuitry (26) is configured to set the functional weight of the first temperature estimate to zero when the rate of change of the first temperature estimate is not positive.

14. The induction cooking appliance (10) of any one of claims 10-13, wherein the control circuitry (26) is configured to detect food insertion into the cookware (18) based on the rate of change of the first temperature estimate.

15. The induction cooking appliance (10) of claim 14, wherein the control circuitry (26) is configured to bias the estimated temperature toward the first temperature estimate in response to the food insertion.

**FIG. 1**

EP 4 694 577 A1

**FIG. 2**

**FIG. 3**

EP 4 694 577 A1

**FIG. 4**

66

78

80

Temperature Request

error

PID Controller

$$u[k] = K_p\left(e[k] + \frac{1}{T_i}\sum_{i=0}^{k} e[i]\right)$$

$P_{req}$

Cooktop + Cookware System

68

76

$\omega_c$ — $\omega_{c1}$ -> $\omega_{c2}$ ← Electrical Enable

82

$\dfrac{1}{1+s\tau}$

L

P

$T_g$

72

$\dfrac{s}{s+\omega_c}$

Tp Est

Tp Est
Electrical
HP

Tp Est
Electrical

$\hat{T}_p[k] = K_{el}(L[k] - L_0) + T_0$

Kel

RLS

84

86

Tp Est
Thermal
LP

$\dfrac{\omega_c}{s+\omega_c}$

Tp Est
Thermal

$\begin{cases} \varepsilon[k] = (1 + (a_{11} - Na_{21})T_s) * \varepsilon[k-1] + MT_s * T_g[k-1] + b_1 * P \\ T_p[k] = \varepsilon[k] + N * T_g[k] \end{cases}$

Tp Est

74

60

**FIG. 5**

16

**Expression (1):**

$$\begin{bmatrix} \dot{\hat{T}}_v \\ \dot{\hat{T}}_s \end{bmatrix} = \begin{bmatrix} a_{11} & a_{12} \\ a_{21} & a_{22} \end{bmatrix} \begin{bmatrix} \hat{T}_v \\ \hat{T}_s \end{bmatrix} + \begin{bmatrix} b_{11} & b_{12} & b_{13} \\ b_{21} & b_{22} & b_{23} \end{bmatrix} \begin{bmatrix} P \\ T_s \\ \dot{T}_s \end{bmatrix}$$

where:

$a_{11}...a_{22}$ and $b_{11}...b_{23}$ are coefficients, which can include suitable values from the parameter set 59;

$P$ is the thermal power delivered to the cooking vessel 18, which can represent an instantaneous thermal power;

$T_s$ is the cook-surface temperature, which can be based on signals from either or both of the first temperature sensor 20, or the second temperature sensor 22;

$\hat{T}_s$ is an estimated cook-surface temperature, which can be based on signals from the first temperature sensor 20, the second temperature sensor 22, the power sensor 24, or combination thereof;

$\dot{T}_s$ is a measured rate of change for the cook-surface temperature;

$\dot{\hat{T}}_s$ is an estimated rate of change for the cook-surface temperature;

$\hat{T}_v$ is the estimated vessel temperature, as determined by the temperature module 60;

and

$\dot{\hat{T}}_v$ is an estimated rate of change of the vessel temperature

**Expression (2):**

$$\begin{bmatrix} \dot{\hat{T}}_v \\ \dot{\hat{T}}_s \\ \dot{\hat{T}}_{int} \end{bmatrix} = \begin{bmatrix} a_{11} & a_{12} & a_{13} \\ a_{21} & a_{22} & a_{23} \\ a_{31} & a_{32} & a_{33} \end{bmatrix} \begin{bmatrix} \hat{T}_v \\ \hat{T}_s \\ \hat{T}_{int} \end{bmatrix} + \begin{bmatrix} b_{11} & b_{12} & b_{13} \\ b_{21} & b_{22} & b_{23} \\ b_{31} & b_{32} & b_{33} \end{bmatrix} \begin{bmatrix} P \\ T_s \\ \dot{T}_s \end{bmatrix}$$

where:

$a_{11}...a_{33}$ and $b_{11}...b_{33}$ are coefficients, which can include suitable values from the parameter set 59;

$P$ is the thermal power delivered to the cooking vessel 18, which can represent an instantaneous thermal power;

$\hat{T}_{int}$ is an estimated temperature of the ambient air beneath the cook surface 14;

$\dot{\hat{T}}_{int}$ is an estimated rate of change for the temperature of the ambient air beneath the cook surface 14,

$T_s$ is the cook-surface temperature, which can be based on signals from either or both of the first temperature sensor 20, or the second temperature sensor 22;

$\hat{T}_s$ is an estimated cook-surface temperature, which can be based on signals from the first temperature sensor 20, the second temperature sensor 22, the power sensor 24, or combination thereof;

$\dot{T}_s$ is a measured rate of change for the cook-surface temperature;

$\dot{\hat{T}}_s$ is an estimated rate of change for the cook-surface temperature;

$\hat{T}_v$ is the estimated vessel temperature, as determined by the temperature module 60;

and

$\dot{\hat{T}}_v$ is an estimated rate of change of the vessel temperature

# FIG. 6A

**Expression 3:**
$$\xi = \dot{\hat{T}}_v - NT_s$$

**Expression 4:**
$$\begin{cases} \dot{\xi} = (a_{11} - Na_{21})\xi + (a_{12} - Na_{22} + Na_{11} - N^2a_{21})T_s + b_1P \\ \hat{T}_v = \xi + NT_s \end{cases}$$

where:

$a11 \ldots a22$ and $b1$ are coefficients, which can include suitable values from the parameter set 59;

$P$ is the thermal power delivered to the cooking vessel 18, which can represent an instantaneous thermal power in some examples;

$T_s$ is the cook-surface temperature based on signals from either or both of the first temperature sensor 20 or the second temperature sensor 22;

$\hat{T}_v$ is the estimated vessel temperature, as determined by the temperature module 60;

$\dot{\hat{T}}_v$ is an estimated rate of change of the vessel temperature; and

$N$ is a convergence rate

# FIG. 6B

EP 4 694 577 A1

**Expression 6:**

$$\begin{cases} \dot{\hat{T}}_V = a_{11}\hat{T}_V + a_{12}T_S + b_1 P + N(\dot{T}_S - \dot{\hat{T}}_S) \\ \dot{\hat{T}}_S = a_{21}\hat{T}_V + a_{22}T_S \end{cases}$$

$$X_L(t) - X_{L_0} \propto T_V(t) - T_{V_0}$$

**Expression 5:**  where $X_L(t)$ is the reactive inductance at time t, $X_{L_0}$ is the inductive reactance at time 0, and equivalently $T_{PAN}(t)$ is the pan temperature at t, and $T_{PAN_0}$ is the pan temperature at time 0

$$\lambda[k] = \left[\beta + \alpha T_{el,HP}[k]\right]_{\lambda_{min}}^{\lambda_{max}}$$

where

**Expression 7:**

$$\alpha = \begin{cases} \dfrac{1}{K_{el}} & \dfrac{1}{K_{el}} > \alpha_{min} \\ \alpha_{min} & \dfrac{1}{K_{el}} \leq \alpha_{min} \end{cases}$$

where $T_{el,HP}$ is the derivative of the electrical estimation

# FIG. 6C

FIG. 6D

FIG. 7A

FIG. 7B

800

802

Detecting a temperature signal indicative of a temperature
of a cook surface of the induction cooking appliance

804

Measuring an inductance of the induction coil

806

Processing the temperature signal and the inductance in a
complementary filter to estimate a temperature of the cookware

**FIG. 8**

| | Europäisches Patentamt European Patent Office Office européen des brevets | **EUROPEAN SEARCH REPORT** | **Application Number** EP 25 19 4380 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 4 231 778 A1 (LG ELECTRONICS INC [KR]) 23 August 2023 (2023-08-23) * paragraph [0002]; figures 1,2 * ----- | 1-15 | INV. H05B6/06 |
| A | US 6 894 255 B2 (MATSUSHITA ELECTRIC INDUSTRIAL CO LTD [JP]) 17 May 2005 (2005-05-17) * figure 1 * ----- | 1-15 | |
| A | EP 3 609 293 A1 (ELECTROLUX APPLIANCES AB [SE]) 12 February 2020 (2020-02-12) * figure 2 * ----- | 1-15 | |
| | | | TECHNICAL FIELDS SEARCHED (IPC) H05B |

The present search report has been drawn up for all claims

| Place of search | Date of completion of the search | Examiner |
|---|---|---|
| Munich | 15 December 2025 | Pierron, Christophe |

## ANNEX TO THE EUROPEAN SEARCH REPORT
## ON EUROPEAN PATENT APPLICATION NO.

EP 25 19 4380

This annex lists the patent family members relating to the patent documents cited in the above-mentioned European search report.
The members are as contained in the European Patent Office EDP file on
The European Patent Office is in no way liable for these particulars which are merely given for the purpose of information.

15-12-2025

| Patent document cited in search report | | | Publication date | Patent family member(s) | | Publication date |
|---|---|---|---|---|---|---|
| EP 4231778 | A1 | 23-08-2023 | | EP | 4231778 A1 | 23-08-2023 |
| | | | | KR | 20230126127 A | 29-08-2023 |
| | | | | US | 2023269836 A1 | 24-08-2023 |
| US 6894255 | B2 | 17-05-2005 | | CN | 1447627 A | 08-10-2003 |
| | | | | EP | 1347669 A2 | 24-09-2003 |
| | | | | EP | 1933599 A2 | 18-06-2008 |
| | | | | EP | 1933600 A2 | 18-06-2008 |
| | | | | KR | 20030076436 A | 26-09-2003 |
| | | | | US | 2003178416 A1 | 25-09-2003 |
| EP 3609293 | A1 | 12-02-2020 | | AU | 2019317728 A1 | 21-01-2021 |
| | | | | EP | 3609293 A1 | 12-02-2020 |
| | | | | US | 2021315064 A1 | 07-10-2021 |
| | | | | WO | 2020030457 A1 | 13-02-2020 |

EPO FORM P0459

For more details about this annex : see Official Journal of the European Patent Office, No. 12/82

**REFERENCES CITED IN THE DESCRIPTION**

**Patent documents cited in the description**

- US 39040223